# EUROPEAN PATENT APPLICATION

(11) **EP 1 754 981 A1**
(43) Date of publication of application: **21.02.2007**
(21) Application number: 05741568.9
(22) Date of filing: 20.05.2005
(51) Int. Cl.: G01T 1/202, C09K 11/00, C09K 11/08, C09K 11/55, C09K 11/62, C09K 11/64, C30B 7/10, C30B 29/16, G01T 1/20

(54) **ZnO SINGLE CRYSTAL AS SUPER HIGH SPEED SCINTILLATOR AND METHOD FOR PREPARATION THEREOF**

(30) Priority: 24.05.2004 JP 2004153753
(71) Applicant: Fukuda X'Tal Laboratory, Sendai-shi, Miyagi 989-3204 (JP)
(72) Inventor: FUKUDA, Tsuguo, 9818007 (JP); YOSHIKAWA, Akira, 9820826 (JP); OGINO, Hiraku, 9810944 (JP)
(74) Representative: Seiffert, Klaus
(86) International application number: PCT/JP2005/009243
(87) International publication number: WO 2005/114256

(57) **Abstract**

[PROBLEMS]

To find out a crystalline material for a high speed scintillator in place of BaF₂ and the like, and a method for producing the material at a low cost.

[MEANS FOR SOLVING PROBLEMS]

A single crystal of (Zn₁₋ₓMₓ)O₁₊ₓ (M: Al, Ga, In, Y, Sc, La, Gd, Lu) (x = 0 to 0.0500), (Zn₁₋ₓM'ₓ)O₁₊₂ₓ(M': Si, Ge, Sn, Pb)(x = 0 to 0.0250) or (Zn₁₋ₓCdₓ)O (x = 0 to 0.0500) is used as a scintillator. Defects of a ZnO single crystal can be reduced by using a platinum inner cylinder in order for a solution not to directly contact with an autoclave, for reducing impurities in the ZnO single crystal and precluding impurities interfering with scintillation, and by using LiOH and KOH as a mineralizer. ZnO can be doped with Al₂O₃, Ga₂O₃, In₂O₃, Si, Cd or the like by adding those materials to a starting material for the hydrothermal synthesis. The doping amounts can be controlled by changing charging amounts thereof. The doping of those elements inhibits the emission of visible lights, which results in the efficient transformation of the excitation energy to the luminescence from a free exciton.

## Description

### BACKGROUND OF THE INVENTION

### Field of the Invention

The present invention relates to a crystal to be used as a scintillator in a scintillation detector.

### Description of the Related Art

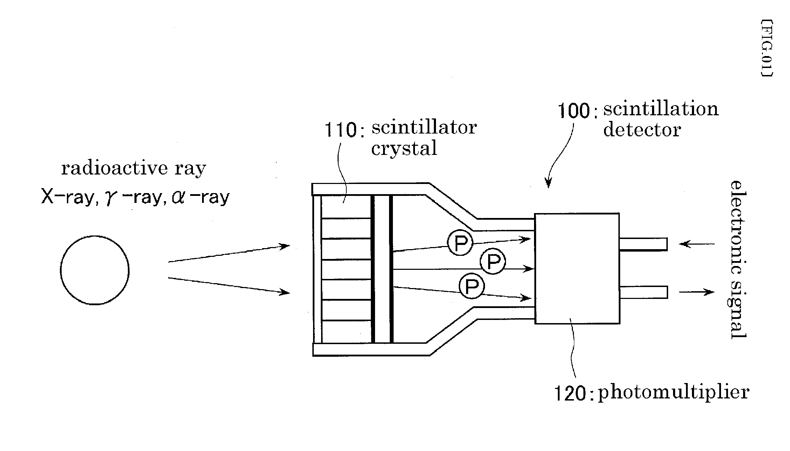

Devices for measuring ionizing radiation include a scintillation detector. The mechanism of a typical scintillation detector is shown in Fig. 1. In Fig. 1, when an ionizing radiation is incident on a scintillation detector 100, fluorescence according to the incoming ionizing radiation is generated in a scintillator crystal 110, and this fluorescence is amplified by a photomultiplier 120 and detected, whereby the ionizing radiation can be measured.

As a candidate for next-generation medical imaging system, a Time-of-Flight (TOF) system has been proposed and investigated, focusing on fluorides. In time-resolved measurement, the resolution can be improved more as the fluorescence lifetime is shorter. Therefore, BaF₂ has been considered to be the candidate. However, it has serious problems such that its small light yield and short emission wavelength and it requires an expensive photomultiplier (PMT) with quartz window. General photomultiplier (PMT) is not available for the detection of luminescence from BaF₂. Each of the problems will be described.

### [Fluorescence Lifetime]

A scintillator having a fluorescence lifetime of not more than 1 ns is required for a Time-Of-Flight type PET (hereinafter referred to as TOF-PET for short) that is considered as a next-generation PET scanner. For this purpose, scintillator with different luminescence mechanism from conventional materials (Bi₄Ge₃O₁₂ (BGO); ~400 ns, Ce:Lu₂SiO₅ (Ce:LSO); ~40 ns) is required. Barium fluoride (BaF₂) is regarded as a leading candidate material for TOF-PET scanner because its fluorescence lifetime of luminescence by cross luminescence (CL) is 0.8 ns. This value is the shortest among currently known sincillators, whose bulk crystals are available to produce. However, scintillator with much shorter lifetime is desirable for the TOF-PET.

### [Emission Amount]

The light yield of BaF₂, that is a candidate material for the TOF-PET scintillator, is about 10 to 20% compared with that of BGO. BGO is a conventional and well known scintillator material; however, it is insufficient for manufacture of a high-sensitivity PET. Moreover, BaF2 has one more serious problem. It has luminescence with long fluorescence lifetime (~600 ns), which is called self-trapped exciton (STE). This luminescence prevents the detection of the luminescence from CL, since it is more intensive than the luminescence by CL.

### [Luminous Wavelength]

BaF₂ further has problems in the price as the whole device or the sensitivity, since an expensive PMT with quartz window must be used because of its short emission wavelength of 180-220 nm (general PMT cannot be used).

### [Chemical Stability]

BaF₂ is hygroscopic, although it is not serious magnitude. It has a tendency to be lower the quality by reaction with moisture in the air. Therefore, coating, vacuum encapsulation or usage of inert gas atmosphere is needed for its long-term use.

### [Density of Crystal]

The PET scanner must have high efficiency of absorbing γ-ray, which is a high-energy particle beam. The capability of absorbing γ-ray depends on the average atomic numbers of atoms constituting a crystal and the density of the crystal. The larger the value, the higher the capability. Since BaF₂ has low γ-ray stopping power with a density of 4.89 g/cm³. This value is low as a scintillator material, therefore, a long piece is required for absorbing of γ-ray, which causes reduced position resolution.

### [Production Price]

Since BaF₂ is a fluoride, it forms oxy fluoride if an oxygen source is present in the growth condition. Thus, the raw material must be carefully prepared so as to minimize impurities of oxygen source. A precise atmospheric control must be performed during the production from the viewpoint of oxygen source removal, which needs special raw material treatment and crystal producing apparatus, resulting in a slightly increased price of crystal.

### SUMMARY OF THE INVENTION

### Problems to be solved by the Invention

An object of the present invention is to find out a new scintillator material in place of BaF₂, and find out a method for producing this material at low cost.

### Means for solving the Problem

The present invention involves a scintillation detector, using a single crystal of (Zn₁₋ₓMₓ)O₁₊ₓ (M: Al, Ga, In, Y, Sc, La, Gd, Lu) (x=0 to 0.0500), (Zn₁₋ₓM'ₓ)O₁₊₂ₓ (M': Si, Ge, Sn, Pb) (x=0 to 0.0250) or (Zn₁₋ₓCdₓ)O (x=0 to 0.0500) as a scintillator. In this case, luminescence by exciton from the single crystal of (Zn₁₋ₓMₓ)O₁₊ₓ (M: Al, Ga, In, Y, Sc, La, Gd, Lu) (x=0 to 0.0500), (Zn₁₋ₓM'ₓ)O₁₊₂ₓ (M': Si, Ge, Sn, Pb) (x=0 to 0.0250) or (Zn₁₋ₓCdₓ)O (x=0 to 0.0500) is preferably used.

A method for producing the crystal of (Zn₁₋ₓMₓ)O₁₊ₓ (M: Al, Ga, In, Y, Sc, La, Gd, Lu) (x=0 to 0.0500), (Zn₁₋ₓM'ₓ)O₁₊₂ₓ (M': Si, Ge, Sn, Pb) (x=0 to 0.0250) or (Zn₁₋ₓCdₓ)O (x=0 to 0.0500) is hydrothermal method with a platinum inner container in the autoclave. KOH and LiOH are used as a mineralizer. Dopant material M, M' or Cd is mixed with starting material in the mineralizer aqueous solution.

A single crystal of (Zn₁₋ₓMₓ)O₁₊ₓ (M: Al, Ga, In, Y, Sc, La, Gd, Lu) (x=0 to 0.0500), (Zn₁₋ₓM'ₓ)O₁₊₂ₓ (M': Si, Ge, Sn, Pb) (x=0 to 0.0250) or (Zn₁₋ₓCdₓ)O (x=0 to 0.0500), which is produced by a hydrothermal with a platinum inner containner in the autoclave, is also involved in the present invention. KOH and LiOH are used as a mineralizer for the growth. Dopant material M, M' or Cd is mixed with starting material.

### Effect of the Invention

Since a ZnO single crystal (including those doped with Al·Ga·In·Y·Sc·La·Gd·Lu·Si·Ge·Sn·Pb·Cd) as described above has a fluorescence lifetime remarkably shorter than those of conventional materials such as BaF₂. Moreover, the wavelength of the resulting luminance is sufficiently long, a general photomultiplier can be used.

In the case of ZnO powder, a raw material is inexpensive by several digits, compared with BaF₂. Moreover, it is stable in the air without any special treatment.

Further, since mass production is possible by adaptation of the hydrothermal method, the ZnO crystal can be produced at low cost. This is apparent from the example of quartz.

### BRIEF DESCRIPTION OF THE DRAWINGS

Fig. 1 is a view showing the setup of a typical scintillation detector;
Fig. 2 is a view showing the structure of a hydrothermal furnace;
Fig. 3 is a view showing X-ray rocking curve measurement data of ZnO single crystal;
Fig. 4 is a view showing an emission spectrum of ZnO single crystal at room temperature. It is excited by UV;
Figs. 5 (a) to (e) are views showing emission spectra of Al-doped ZnO single crystals at room temperature. It is excited by UV. Doping concentration is as follows; (a) Al: 0.1%, (b) Al: 0.5%, (c) Al: 1.0%, (d) Al: 5.0%, and (e) Al: 15%;
Figs. 6 (a) to (e) are views showing emission spectra of Ga-doped ZnO single crystals at room temperature. It is excited by UV. Doping concentration is as follows; (a) Ga: 0.1%, (b) Ga: 0.5%, (c) Ga: 1.0%, (d) Ga: 5.0%, and (e) Ga: 15%;
Fig. 7 (a) to (e) are views showing emission spectra of In-doped ZnO single crystals at room temperature. It is excited by UV. Doping concentration is as follows; (a) In: 0.1%, (b) In: 0.5%, (c) In: 1.0%, (d) In: 5.0%, and (e) In: 15%;
Fig. 8 (a) to (e) are views showing emission spectra of Y-doped ZnO single crystals at room temperature. It is excited by UV. Doping concentration is as follows; (a) Y: 0.1%, (b) Y: 0.5%, (c) Y: 1.0%, (d) Y: 5.0%, and (e) Y: 15%;
Fig. 9 (a) to (e) are views showing emission spectra of Sc-doped ZnO single crystals at room temperature. It is excited by UV. Doping concentration is as follows; (a) Sc: 0.1%, (b) Sc: 0.5%, (c) Sc: 1.0%, (d) Sc: 5.0%, and (e) Sc: 15%;
Fig. 10 (a) to (e) are views showing emission spectra of La-doped ZnO single crystals at room temperature. It is excited by UV. Doping concentration is as follows; (a) La: 0.1%, (b) La: 0.5%, (c) La: 1.0%, (d) La: 5.0%, and (e) La: 15%;
Fig. 11 (a) to (e) are views showing luminescence emission spectra of Gd-doped ZnO single crystals at room temperature. It is excited by UV. Doping concentration is as follows; (a) Gd: 0.1%, (b) Gd: 0.5%, (c) Gd: 1.0%, (d) Gd: 5.0%, and (e) Gd: 15%;
Fig. 12 (a) to (e) are views showing luminescence emission spectra of Lu-doped ZnO single crystals at room temperature. It is excited by UV. Doping concentration is as follows; (a) Lu: 0.1%, (b) Lu: 0.5%, (c) Lu: 1.0%, (d) Lu: 5.0%, and (e) Lu: 15%;
Fig. 13 (a) to (e) are views showing luminescence emission spectra of Si-doped ZnO single crystals at room temperature. It is excited by UV. Doping concentration is as follows; (a) Si: 0.1%, (b) Si: 0.25%, (c) Si: 0.5%, (d) Si: 2.5%, and (e) Si: 15%;
Fig. 14 (a) to (e) are views showing luminescence emission spectra of Ge-doped ZnO single crystals at room temperature. It is excited by UV. Doping concentration is as follows; (a) Ge: 0.1%, (b) Ge: 0.25%, (c) Ge: 0.5%, (d) Ge: 2.5%, and (e) Ge: 15%;
Fig. 15 (a) to (e) are views showing luminescence emission spectra of Sn-doped ZnO single crystals at room temperature. It is excited by UV. Doping concentration is as follows; (a) Sn: 0.1%, (b) Sn: 0.25%, (c) Sn: 0.5%, (d) Sn: 2.5%, and (e) Sn: 15%;
Fig. 16 (a) to (e) are views showing luminescence emission spectra of Pb-doped ZnO single crystals at room temperature. It is excited by UV. Doping concentration is as follows; (a) Pb: 0.1%, (b) Pb: 0.25%, (c) Pb: 0.5%, (d) Pb: 2.5%, and (e) Pb: 15%; and
Fig. 17 (a) to (e) are views showing luminescence emission spectra of Cd-doped ZnO single crystals at room temperature. It is excited by UV. Doping concentration is as follows; (a) Cd: 0.1%, (b) Cd: 0.5%, (c) Cd: 1.0%, (d) Cd: 5.0%, and (e) Cd: 15%.

### BEST MODE FOR CARRYING OUT THE INVENTION

In the course of studies for single crystals of ZnO, the present inventors found out that ZnO single crystals as described above are prominent as scintillator materials.

ZnO single crystal is generally produced by flux method, CVT method, hydrothermal method, and so on. However, since those produced by the general methods include impurities (Fe, Ni, Cr, etc.) which inhibit light emission, and have high density of crystal defects, the energy excited by X-ray, γ-ray or other ionizing radiation is thermally reduced or it turned to be a visible light with long decay time.

In the growth of ZnO single crystal by a conventional hydrothermal method, only the increase in quality of the crystal was focused, and a dissimilar element small doping method has not been established. Further, there is no mechanism for efficient light emission, capable of preventing absorption of precious luminescence by exciton by itself (self-absorption) in undoped ZnO which is caused by overlapping of the absorption wavelength band of ZnO itself with the wavelength of the luminescence by exciton. Further, most of the luminescence by exciton is trapped by crystal defects, and thermally reduced or it turned to be a visible light with long decay time.

The inventors found out that a single crystal of ZnO can be produced by hydrothermal method using the Pt container. It reduces the impurities, and therefore, doping can be also possible, as described below.

### [Technique for producing ZnO single crystal]

For reducing impurities in ZnO single crystal such as Fe, Ni or Cr which inhibit light emission, a platinum inner container is effective. It makes solution not to directly contact with an autoclave. As a result, LiOH and KOH can be used in appropriate quantities as a mineralizer, consequently, defects of the ZnO single crystal can be consequently reduced.

### [Technique for doping ZnO single crystal]

Doping to ZnO can be performed by adding Al₂O₃, Ga₂O₂, In₂O₃, Y₂O₃, Sc₂O₃, La₂O₃, Gd₂O₃, Lu₂O₃, SiO₂, GeO₂, SnO₂, PbO, CdO and so on. They are mixed with starting material or mineralizer aqueous solution. Further, the doping amount can be controlled by changing the charging amount. Further, by doping these elements, the emission wavelength is shifted to long wavelength side, resulting in the suppression of the self-absorption, and the luminescence by exciton can be efficiently taken out (detected).

### [Annealing Technique]

Reduction of distortion in the crystal surface, which suppress the emission intensity, can be reduced by performing annealing at 1000 to 1400°C for 5 to 15 hours in oxygen atmosphere. Consequently, the excitation energy can be efficiently transformed to the luminescence center.

### [Fluorescence Lifetime]

The fluorescence lifetime of the luminescence by free exciton of ZnO is about 0.6 ns which is shorter than that of BaF₂ and sufficiently satisfies the value necessary for the TOF-type PET.

### [Emission Intensity]

The emission intensity of luminescence from ZnO, which is strongly depending on the amount of impurities, can be increased by controlling the amount of impurities and the concentration of the dopant. Although luminescence with long fluorescence lifetime by impurities is present at about 500 nm, this luminescence can be also inhibited by controlling the amount of impurities.

### [Luminous Wavelength]

The luminescence from free exciton of ZnO has emission peaking around 370 nm and general PMT can be used.

### [Chemical Stability]

As it is oxide, ZnO is stable in the air, and free from the problems of hygroscopicity.

### [Density]

This crystal is intended to convert a radioactive ray such as γ-ray or X-ray to visible light as a scintillator crystal. The higher density is more suitable for efficient absorption of γ-ray or X-ray, and ZnO has a density of 5.61 g/cm³, and it has better stopping power than that of BaF₂.

### [Production Price]

At this moment, ZnO single crystal is rather expensive. This is because it is produced by vapor-phase growth. However, now it can be grown by the hydrothermal method. This growth method is same as artificial quartz, whose is famous for economical price.

The use of the single crystal or doped crystals of ZnO produced by the above-mentioned method as a scintillator leads to the following effects.
1. The amount of impurities is reduced by using a platinum liner and using KOH and LiOH as a mineralizer in the growth of ZnO single crystal by the hydrothermal synthetic method.
2. A dissimilar element doping method by hydrothermal synthetic method is established for efficiently taking out the luminescence by exciton from the ZnO single crystal.
3. The fluorescence lifetime of the luminescence by free exciton of ZnO is extremely short as about 0.6 ns, which sufficiently satisfies the value necessary for the scintillator crystal for TOF-type PET.
4. The light yield equal to that of BGO which is a conventional material can be attained by controlling the amount of impurities in the ZnO single crystal and the carrier doping amount by the hydrothermal synthetic method of the present invention. Luminescence by impurities having a peak at about 500 nm is reduced by reducing the amount of impurities and improving the crystallinity, and the emission amount at the vicinity of 370 nm with short fluorescence lifetime can be successfully increased.
5. The emission wavelength of the luminescence by free exciton of ZnO is about 370 nm, and a general PMT can be used.
6. ZnO is stable in the air because it is an oxide, and free from problems such as deliquescence.
7. This crystal is intended to convert an ionizing radiation such as γ-ray or X-ray to visible light as a scintillator crystal. The higher density is desirable for efficient absorption of γ-ray or X-ray, and ZnO has a density of 5.61 g/cm³, and is excellent in γ-ray and X-ray stopping power, compared with BaF₂.
8. At this moment, ZnO single crystal is rather expensive. This is because it is produced by vapor-phase growth. However, now it can be grown by the hydrothermal method. This growth method is same as artificial quartz, whose is famous for economical price.

### EXAMPLE

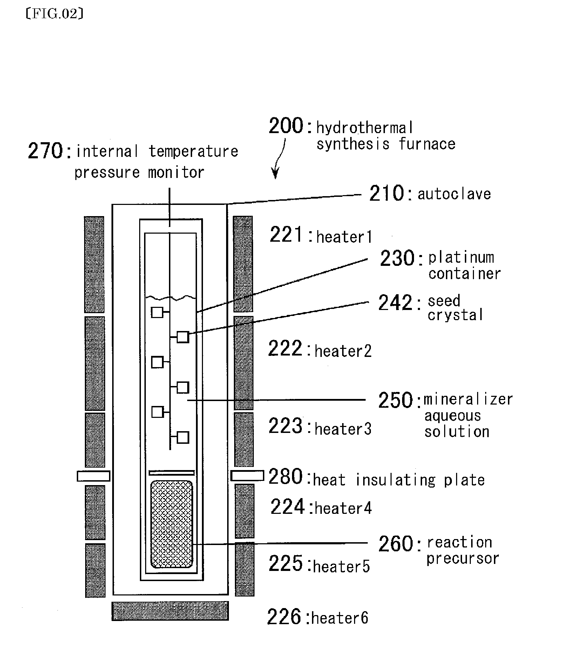

A crystal of ZnO for scintillator which will be described in detail was produced, using a hydrothermal synthesis furnace 200 having a structure as shown in Fig. 2. Within an autoclave 210 that is a pressure vessel, for reducing the impurities of ZnO single crystal and for precluding the impurities such as Fe, Ni or Cr, which prevents light emission, a platinum container 230 is used as an inner cylinder in order for a solution not to directly contact with the autoclave 210. A seed crystal 240, a mineralizer aqueous solution 250 and a reaction precursor 260 are enclosed in the container 230. As the mineralizer aqueous solution 250, an aqueous solution containing LiOH: 1 mol/l and KOH: 3 mol/l is used. In doping, ZnO can be doped by adding Al₂O₃, Ga₂O₃, In₂O₃, Y₂O₃, Sc₂O₃, La₂O₃, Gd₂O₃, Lu₂O₃, SiO₂, GeO₂, SnO₂, PbO, CdO or the like to the reaction precursor 260 or the mineralizer aqueous solution 250 that is a starting material for hydrothermal synthesis. The doping amount is controlled by changing the charging amount (starting composition) of the doping material.

A heater 1 211 to a heater 6 216 for heating are set on the outside of the autoclave 210. The platinum container 230 is partitioned by a heat insulating plate 280 to an upper part and a lower part having a temperature difference of about 20°C. The one melted from the reaction precursor 260 in the lower part of the platinum container 230 is crystallized in the seed crystal 240 in the upper part. The mineralizer aqueous solution 250 is used to promote the crystallization.

The growing condition of the ZnO crystal formed in the hydrothermal synthetic furnace 200 is shown in Tables 1(a), 1(b), and 1(c). In the tables, x represents a composition ratio of (Zn₁₋ₓMₓ)O₁₊ₓ (M: Al, Ga, In, Y, Sc, La, Gd, Lu) or a composition ratio of (Zn₁₋ₓM'ₓ)O₁₊₂ₓ (M': Si, Ge, Sn, Pb) or (Zn₁₋ₓCdₓ)O.

**Table 1(a)**

| Compound Composition (Starting Composition) | | Starting Material | Growing Temperature (lower part, upper part) Growing Pressure Container Material |
|---|---|---|---|
| ZnO | | ZnO (4N) | 400°C, 380°C 90MPa Pt |
| Al:ZnO | | ZnO (4N) Al₂O₃ (5N) | 400°C, 380°C 90MPa Pt |
| x= | | | |
| 0.001 | (0.1%) | | |
| 0.005 | (0.5%) | | |
| 0.01 | (1%) | | |
| 0.05 | (5%) | | |
| 0.15 | (15%) | | |
| Ga:ZnO | | ZnO (4N) Ga₂O₃ (4N) | 400°C, 380°C 90MPa Pt |
| x= | | | |
| 0.001 | (0.1%) | | |
| 0.005 | (0.5%) | | |
| 0.01 | (1%) | | |
| 0.05 | (5%) | | |
| 0.15 | (15%) | | |
| In:ZnO | | ZnO (4N) Zn₂O₃ (5N) | 400°C, 380°C 90MPa Pt |
| x= | | | |
| 0.001 | (0.1%) | | |
| 0.005 | (0.5%) | | |
| 0.01 | (1%) | | |
| 0.05 | (5%) | | |
| 0.15 | (15%) | | |
| Y:ZnO | | ZnO (4N) Y₂O₃ (5N) | 400°C, 380°C 90MPa Pt |
| x= | | | |
| 0.001 | (0.1%) | | |
| 0.005 | (0.5%) | | |
| 0.01 | (1%) | | |
| 0.05 | (5%) | | |
| 0.15 | (15%) | | |
| Sc:ZnO | | ZnO (4N) Sc₂O₃ (5N) | 400°C, 380°C 90MPa Pt |
| x= | | | |
| 0.001 | (0.1%) | | |
| 0.005 | (0.5%) | | |
| 0.01 | (1%) | | |
| 0.05 | (5%) | | |
| 0.15 | (15%) | | |

**Table 1(b)**

| Compound Composition (Starting Composition) | | Starting Material | Growing Temperature (lower part, upper part) Growing Pressure Container Material |
|---|---|---|---|
| La:ZnO | | ZnO (4N) La₂O₃ (5N) | 400°C, 380°C 90MPa Pt |
| x= | | | |
| 0.001 | (0.1%) | | |
| 0.005 | (0.5%) | | |
| 0.01 | (1%) | | |
| 0.05 | (5%) | | |
| 0.15 | (15%) | | |
| Gd:ZnO | | ZnO (4N) Gd₂O₃ (5N) | 400°C, 380°C 90MPa Pt |
| x= | | | |
| 0.001 | (0.1%) | | |
| 0.005 | (0.5%) | | |
| 0.01 | (1%) | | |
| 0.05 | (5%) | | |
| 0.15 | (15%) | | |
| Lu:ZnO | | ZnO (4N) Lu₂O₃ (5N) | 400°C, 380°C 90MPa Pt |
| x= | | | |
| 0.001 | (0.1%) | | |
| 0.005 | (0.5%) | | |
| 0.01 | (1%) | | |
| 0.05 | (5%) | | |
| 0.15 | (15%) | | |
| Si:ZnO | | ZnO (4N) SiO₂ (5N) | 400°C, 380°C 90MPa Pt |
| x= | | | |
| 0.001 | (0.1%) | | |
| 0.0025 | (0.25%) | | |
| 0.01 | (0.5%) | | |
| 0.05 | (2.5%) | | |
| 0.15 | (15%) | | |

**Table 1(c)**

| Compound Composition (Starting Composition) | | Starting Material | Growing Temperature (lower part, upper part) Growing Pressure Container Material |
|---|---|---|---|
| Ge:ZnO | | ZnO (4N) GeO₂ (5N) | 400°C, 380°C 90MPa Pt |
| x= | | | |
| 0.001 | (0.1%) | | |
| 0.0025 | (0.25%) | | |
| 0.01 | (0.5%) | | |
| 0.05 | (2.5%) | | |
| 0.15 | (15%) | | |
| Sn:ZnO | | ZnO (4N) SnO₂ (5N) | 400°C, 380°C 90MPa Pt |
| x= | | | |
| 0.001 | (0.1%) | | |
| 0.0025 | (0.25%) | | |
| 0.01 | (0.5%) | | |
| 0.05 | (2.5%) | | |
| 0.15 | (15%) | | |
| Pb:ZnO | | ZnO (4N) PbO (5N) | 400°C, 380°C 90MPa Pt |
| x= | | | |
| 0.001 | (0.1%) | | |
| 0.0025 | (0.25%) | | |
| 0.01 | (0.5%) | | |
| 0.05 | (2.5%) | | |
| 0.15 | (15%) | | |
| Cd:ZnO | | ZnO (4N) CdO (4N) | 400°C, 380°C 90MPa Pt |
| x= | | | |
| 0.001 | (0.1%) | | |
| 0.0025 | (0.25%) | | |
| 0.01 | (1%) | | |
| 0.05 | (5%) | | |
| 0.15 | (15%) | | |

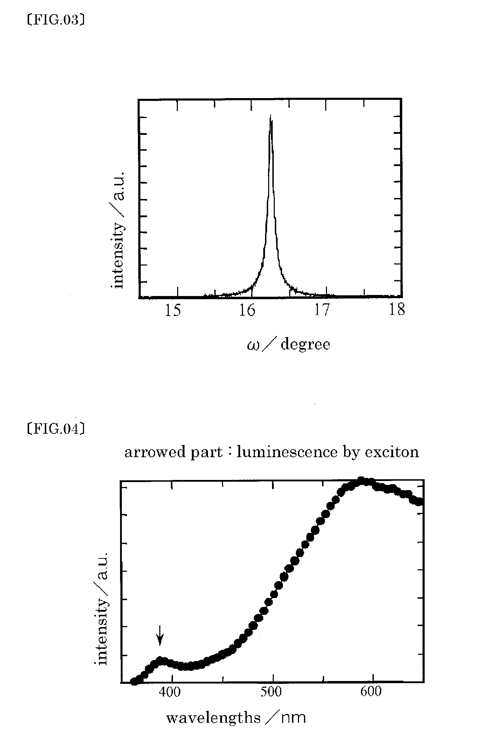

Ga-doped Zn crystals, In-doped ZnO crystals, Y-doped ZnO crystals, Sc-doped Zn crystals, La-doped ZnO crystals, Gd-doped ZnO crystals, Lu-doped Zn crystals, Si-doped ZnO crystals, Ge-doped ZnO crystals, Sn-doped ZnO crystals, Pb-doped Zn crystals and Pb-doped Zn crystals, which were formed in the above-mentioned growing conditions will be described in Figs. 3 to 16.

Fig. 3 shows X-ray rocking curve measurement data of the undoped ZnO single crystal. As is apparent therefrom, the ZnO single crystal formed in the above-mentioned growing condition for hydrothermal synthetic method has extremely high crystallinity with minimized crystalline defects.

Fig. 4 shows a luminescence emission spectrum at room temperature to UV excitation of the ZnO single crystal. It is the luminescence by exciton of the arrowed part in the drawing that is used as a scintillator. The broad peak in visible range cannot be used as the scintillator because of a long lifetime.

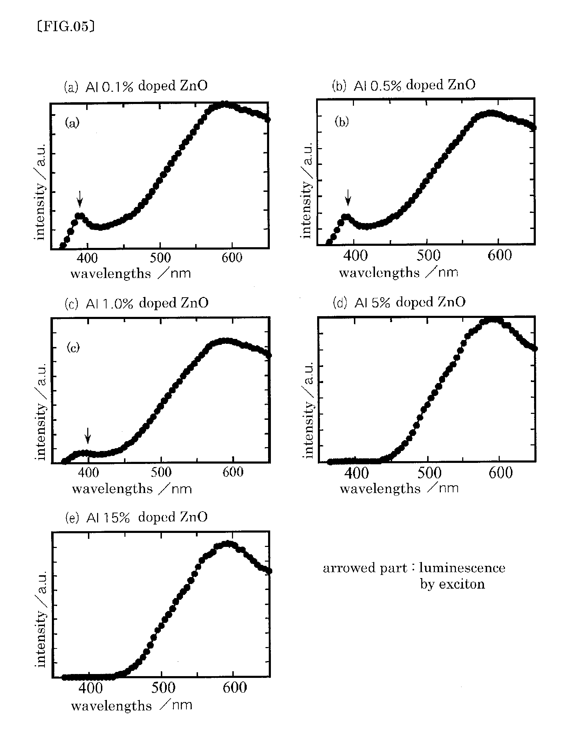

Figs. 5 show luminescence emission spectra at room temperature to UV excitation of the Al-doped ZnO single crystals. It is also the luminescence by exciton of the arrowed part in the drawings that is used as the scintillator.

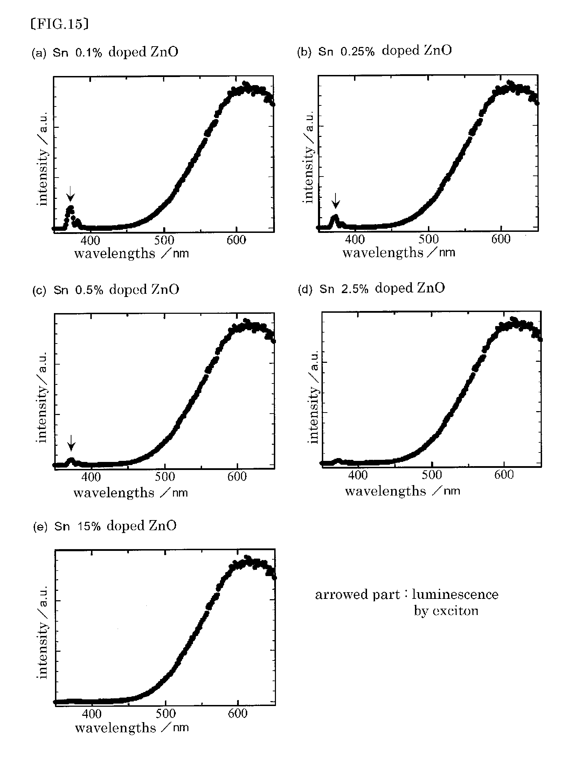

The doping amounts of A1 are 0.1% (composition ratio 0.001) in Fig. 5(a), 0.5% (composition ratio 0.005) in Fig. 5(b), 1.0% (composition ratio 0.01) in Fig. 5(c), 5.0% (composition ratio 0.05) in Fig. 5(d), 15% (composition ratio 0.15) in Fig. 5(e), respectively. As is apparent from these drawings, the luminescence by exciton was observed with Al: not more than 1.0%.

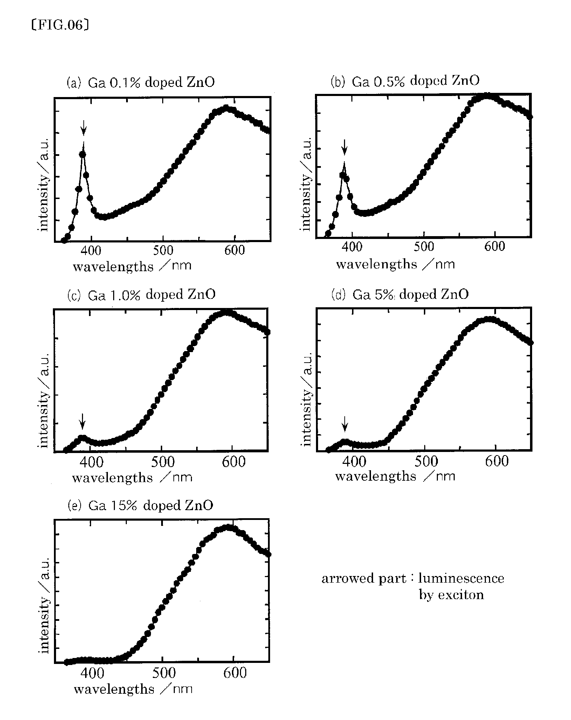

Figs. 6 show luminescence emission spectra at room temperature to UV excitation of the Ga-doped ZnO single crystals. It is also the luminescence by exciton of the arrowed part in the drawings that is used as the scintillator.

The doping amounts of Ga are 0.1% (composition ratio 0.001) in Fig. 6(a), 0.5% (composition ratio 0.005) in Fig. 6(b), 1.0% (composition ratio 0.01) in Fig. 6(c), 5.0% (composition ratio 0.05) in Fig. 6(d), 15% (composition ratio 0.15) in Fig. 6(e), respectively. As is apparent from these drawings, the luminescence by exciton was observed with Ga: not more than 5.0%.

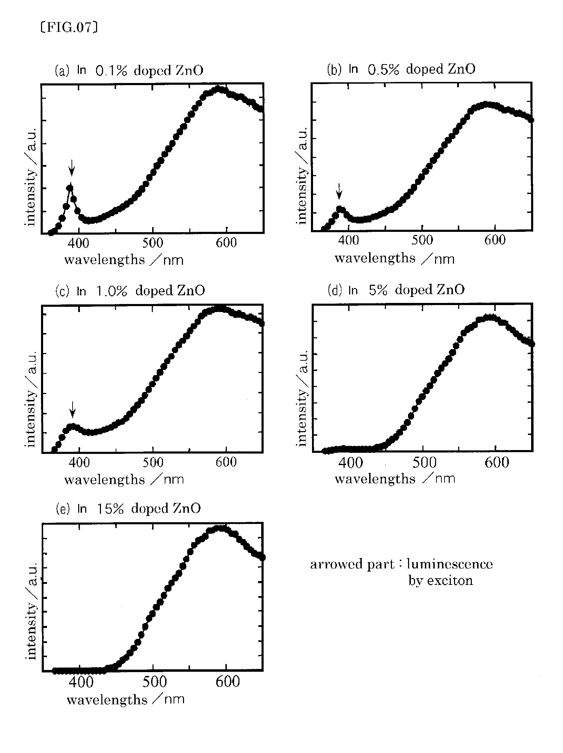

Figs. 7 show luminescence emission spectra at room temperature to UV excitation of the In-doped ZnO single crystals. It is also the luminescence by exciton of the arrowed part in the drawings that is used as the scintillator.

The doping amounts of In are 0.1% (composition ratio 0.001) in Fig. 7(a), 0.5% (composition ratio 0.005) in Fig. 7(b), 1.0% (composition ratio 0.01) in Fig. 7(c), 5.0% (composition ratio 0.05) in Fig. 7(d), 15% (composition ratio 0.15) in Fig. 7(e), respectively. As is apparent from these drawings, the luminescence by exciton was observed with In: not more than 1.0%.

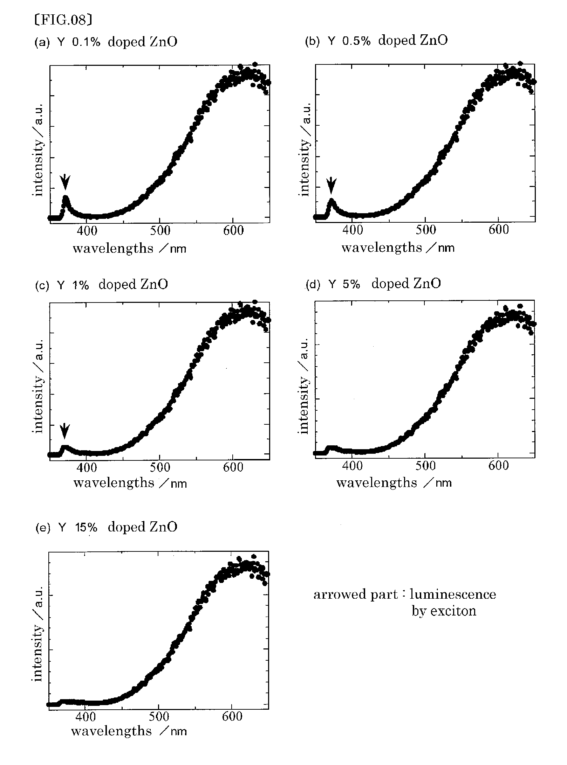

Figs. 8 show luminescence emission spectra at room temperature to UV excitation of the Y-doped ZnO single crystals. It is also the luminescence by exciton of the arrowed part in the drawings that is used as the scintillator.

The doping amounts of Y are 0.1% (composition ratio 0.001) in Fig. 8(a), 0.5% (composition ratio 0.005) in Fig. 8(b), 1.0% (composition ratio 0.01) in Fig. 8(c), 5.0% (composition ratio 0.05) in Fig. 8(d), 15% (composition ratio 0.15) in Fig. 8(e), respectively. As is apparent from these drawings, the luminescence by exciton was observed with Y: not more than 1.0%.

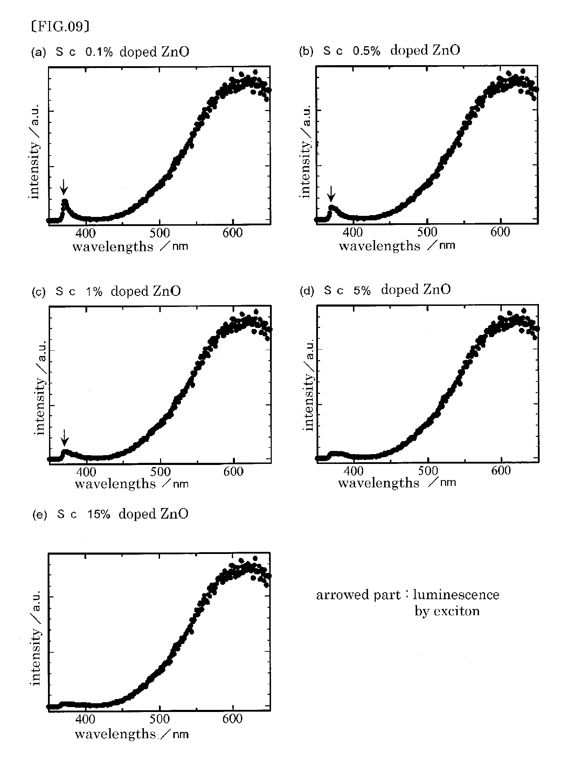

Figs. 9 show luminescence emission spectra at room temperature to UV excitation of the Sc-doped ZnO single crystals. It is also the luminescence by exciton of the arrowed part in the drawings that is used as the scintillator.

The doping amounts of Sc are 0.1% (composition ratio 0.001) in Fig. 9(a), 0.5% (composition ratio 0.005) in Fig. 9(b), 1.0% (composition ratio 0.01) in Fig. 9(c), 5.0% (composition ratio 0.05) in Fig. 9(d), 15% (composition ratio 0.15) in Fig. 9(e), respectively. As is apparent from these drawings, the luminescence by exciton was observed with Sc: not more than 1.0%.

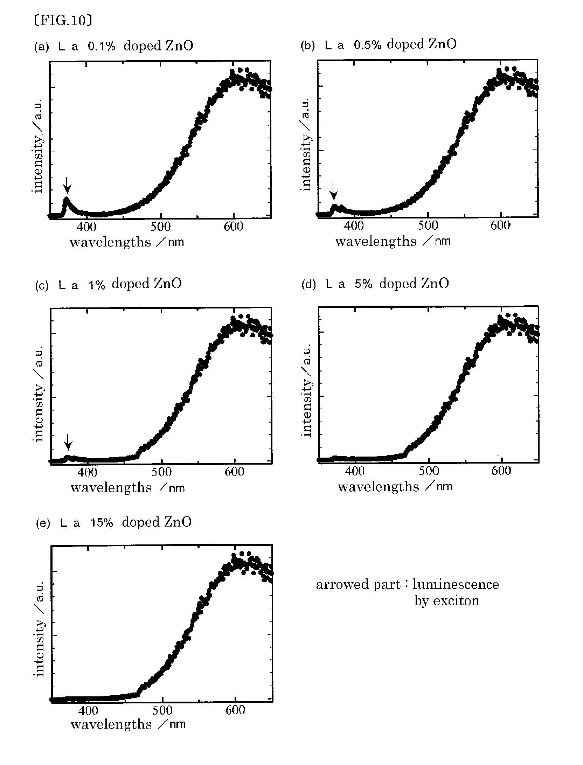

Figs. 10 show luminescence emission spectra at room temperature to UV excitation of the La-doped ZnO single crystals. It is also the luminescence by exciton of the arrowed part in the drawings that is used as the scintillator.

The doping amounts of La are 0.1% (composition ratio 0.001) in Fig. 10(a), 0.5% (composition ratio 0.005) in Fig. 10(b), 1.0% (composition ratio 0.01) in Fig. 10(c), 5.0% (composition ratio 0.05) in Fig. 10(d), 15% (composition ratio 0.15) in Fig. 10(e), respectively. As is apparent from these drawings, the luminescence by exciton was observed with La: not more than 1.0%.

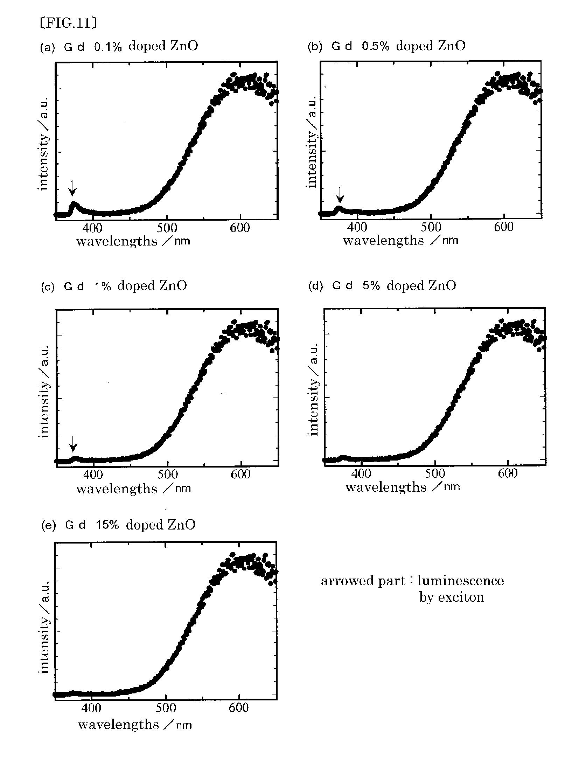

Figs. 11 show luminescence emission spectra at room temperature to UV excitation of the Gd-doped ZnO single crystals. It is also the luminescence by exciton of the arrowed part in the drawings that is used as the scintillator.

The doping amounts of Gd are 0.1% (composition ratio 0.001) in Fig. 11(a), 0.5% (composition ratio 0.005) in Fig. 11(b), 1.0% (composition ratio 0.01) in Fig. 11(c), 5.0% (composition ratio 0.05) in Fig. 11(d), 15% (composition ratio 0.15) in Fig. 11(e), respectively. As is apparent from these drawings, the luminescence by exciton was observed with Gd: not more than 1.0%.

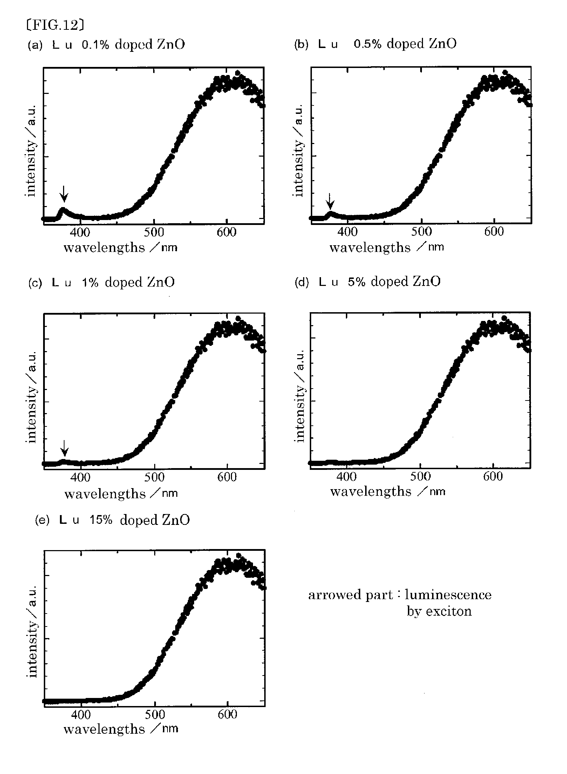

Figs. 12 show luminescence emission spectra at room temperature to UV excitation of the Lu-doped ZnO single crystals. It is also the luminescence by exciton of the arrowed part in the drawings that is used as the scintillator.

The doping amounts of Lu are 0.1% (composition ratio 0.001) in Fig. 12(a), 0.5% (composition ratio 0.005) in Fig. 12(b), 1.0% (composition ratio 0.01) in Fig. 12(c), 5.0% (composition ratio 0.05) in Fig. 12(d), 15% (composition ratio 0.15) in Fig. 12(e), respectively. As is apparent from these drawings, the luminescence by exciton was observed with Lu: not more than 1.0%.

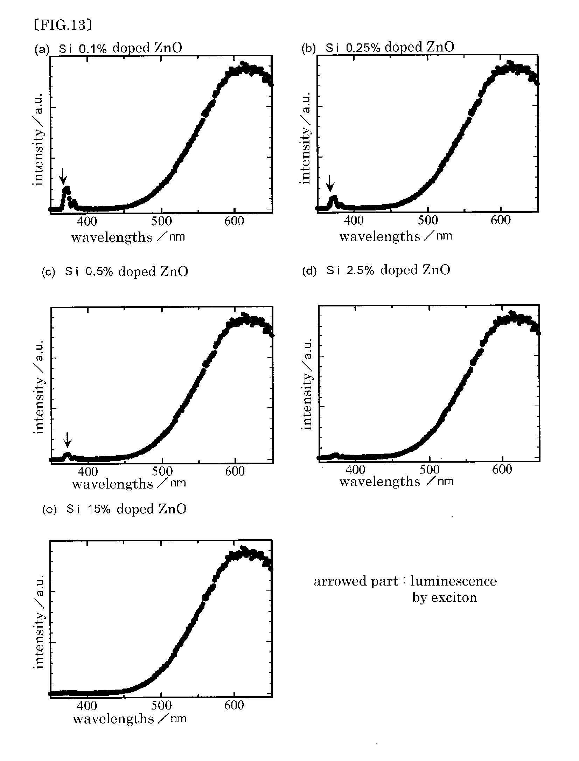

Figs. 13 show luminescence emission spectra at room temperature to UV excitation of the Si-doped ZnO single crystals. It is also the luminescence by exciton of the arrowed part in the drawings that is used as the scintillator.

The doping amounts of Si are 0.1% (composition ratio 0.001) in Fig. 13(a), 0.25% (composition ratio 0.0025) in Fig. 13(b), 0.5% (composition ratio 0.005) in Fig. 13(c), 2.5% (composition ratio 0.025) in Fig. 13(d), 15% (composition ratio 0.15) in Fig. 13(e), respectively. As is apparent from these drawings, the luminescence by exciton was observed with Si: not more than 1.0%.

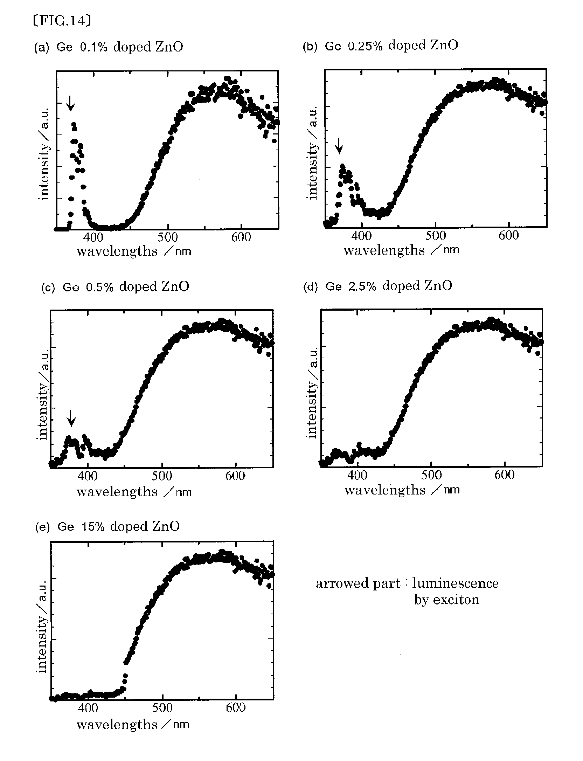

Figs. 14 show luminescence emission spectra at room temperature to UV excitation of the Ge-doped ZnO single crystals. It is also the luminescence by exciton of the arrowed part in the drawings that is used as the scintillator.

The doping amounts of Ge are 0.1% (composition ratio 0.001) in Fig. 14(a), 0.25% (composition ratio 0.0025) in Fig. 14(b), 0.5% (composition ratio 0.005) in Fig. 14(c), 2.5% (composition ratio 0.025) in Fig. 14(d), 15% (composition ratio 0.15) in Fig. 14(e), respectively. As is apparent from these drawings, the luminescence by exciton was observed with Ge: not more than 1.0%.

Figs. 15 show luminescence emission spectra at room temperature to UV excitation of the Sn-doped ZnO single crystals. It is also the luminescence by exciton of the arrowed part in the drawings that is used as the scintillator.

The doping amounts of Sn are 0.1% (composition ratio 0.001) in Fig. 15(a), 0.25% (composition ratio 0.0025) in Fig. 15(b), 0.5% (composition ratio 0.005) in Fig. 15(c), 2.5% (composition ratio 0.025) in Fig. 15(d), 15% (composition ratio 0.15) in Fig. 15(e), respectively. As is apparent from these drawings, the luminescence by exciton was observed with Sn: not more than 1.0%.

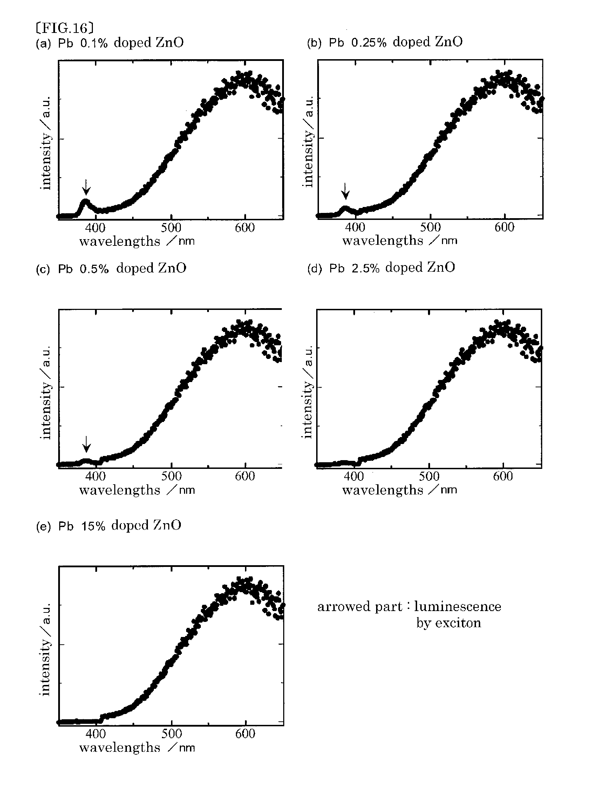

Figs. 16 show luminescence emission spectra at room temperature to UV excitation of the Pb-doped ZnO single crystals. It is also the luminescence by exciton of the arrowed part in the drawings that is used as the scintillator.

The doping amounts of Pb are 0.1% (composition ratio 0.001) in Fig. 16(a), 0.25% (composition ratio 0.0025) in Fig. 16(b), 0.5% (composition ratio 0.005) in Fig. 16(c), 2.5% (composition ratio 0.025) in Fig. 16(d), 15% (composition ratio 0.15) in Fig. 16(e), respectively. As is apparent from these drawings, the luminescence by exciton was observed with Pb: not more than 1.0%.

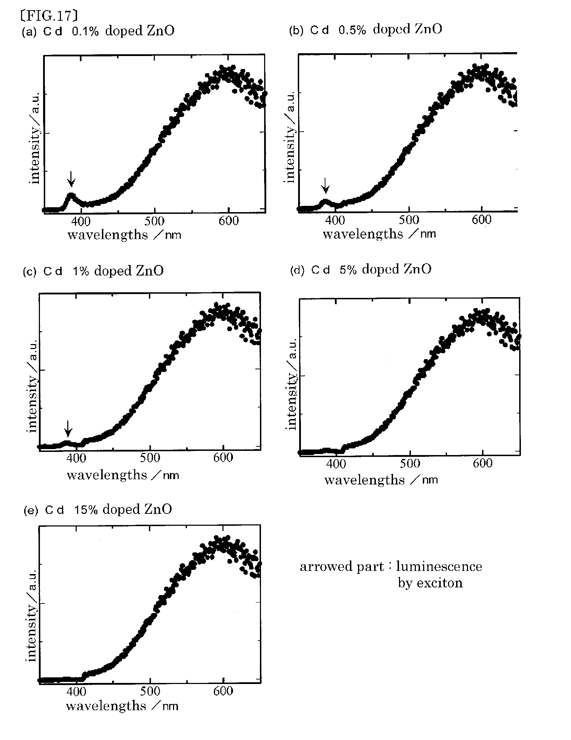

Figs. 17 show luminescence emission spectra at room temperature to UV excitation of the Cd-doped ZnO single crystals. It is also the luminescence by exciton of the arrowed part in the drawings that is used as the scintillator.

The doping amounts of Cd are 0.1% (composition ratio 0.001) in Fig. 17(a), 0.5% (composition ratio 0.005) in Fig. 17(b), 1.0% (composition ratio 0.01) in Fig. 17(c), 5.0% (composition ratio 0.05) in Fig. 17(d), 15% (composition ratio 0.15) in Fig. 17(e), respectively. As is apparent from these drawings, the luminescence by exciton was observed with Cd: not more than 1.0%.

The characteristics of the scintillators using the luminescence by free excitons of Ga:ZnO and Ge:ZnO obtained by the present invention are shown in Table 2 comparatively with those of typical existing scintillator crystals (BGO, BaF₂).

**Table 2**

| | BGO | BaF₂ | Ce:LSO | Ga:ZnO | Ge:ZnO |
|---|---|---|---|---|---|
| Density | 7.13 g/cm³ | 4.88 g/cm³ | 7.4 g/cm³ | 5.61 g/cm³ | 5.61 g/cm³ |
| Luminous Wavelength | 480 nm | 180-220 nm | 420nm | ~370 nm | ~370 nm |
| Fluorescence Lifetime | 400 ns | 0.8 - 0.9 ns | 40ns | < 0.6 ns | < 0.6 ns |
| Emission Amount (Comparison with BGO) | 100 % | 17 % | 400% | 100% | 120% |
| Chemical Stability | High | Middle | High | High | High |
| Price | Middle | Middle | Middle | Low | Low |

As described above, the crystals of ZnO doped with Al, Ga, In, Y, Sc, La, Gd, Lu, Si, Ge, Sn, Pb, Cd and the like by the hydrothermal synthetic method represent quick build up in addition to fluorescence lifetimes of not more than 0.6 ns far beyond those of the conventional materials such as BGO, and clear the reference of not more than 1 ns which is ideal for TOF-PET. Similarly, compared with BaF₂ having a fluorescence lifetime of not more than Ins, these crystals are preferable from each point of density, emission amount, short fluorescence lifetime, chemical stability, and low price. Further, they have luminous wavelengths significantly closer to the long wavelength side than BaF₂, and can be combined with a general PMT.

## Claims

1. A scintillation detector, **characterized by** using a single crystal of (Zn₁₋ₓMₓ)O₁₊ₓ (M: Al, Ga, In, Y, Sc, La, Gd, Lu) (x=0 to 0.0500), (Zn₁₋ₓM'ₓ)O₁₊₂ₓ (M': Si, Ge, Sn, Pb) (x=0 to 0.0250) or (Zn₁₋ₓCdₓ)O (x=0 to 0.0500) as a scintillator.

2. The scintillation detector according to claim 1, wherein luminescence by exciton from the single crystal of (Zn₁₋ₓMₓ)O₁₊ₓ (M: Al, Ga, In, Y, Sc, La, Gd, Lu) (x=0 to 0.0500), (Zn₁₋ₓM'ₓ)O₁₊₂ₓ (M': Si, Ge, Sn, Pb) (x=0 to 0.0250) or (Zn₁₋ₓCdₓ)O (x=0 to 0.0500) is used.

3. A hydrothermal synthetic method for producing a single crystal of (Zn₁₋ₓMₓ)O₁₊ₓ (M: Al, Ga, In, Y, Sc, La, Gd, Lu) (x=0 to 0.0500), (Zn₁₋ₓM'ₓ)O₁₊₂ₓ (M': Si, Ge, Sn, Pb) (x=0 to 0.0250) or (Zn₁₋ₓCdₓ)O (x=0 to 0.0500), comprising using a platinum inner cylinder on the inner side of an autoclave, using KOH and LiOH as a mineralizer aqueous solution, and adding the doping material M, M' or Cd to a starting material or the mineralizer aqueous solution.

4. A single crystal of (Zn₁₋ₓMₓ)O₁₊ₓ (M: Al, Ga, In, Y, Sc, La, Gd, Lu) (x=0 to 0.0500), (Zn₁₋ₓM'ₓ)O₁₊₂ₓ (M': Si, Ge, Sn, Pb) (x=0 to 0.0250) or (Zn₁₋ₓCdₓ)O (x=0 to 0.0500), which is produced by a hydrothermal synthetic method by using a platinum inner cylinder on the inner side of an autoclave, using KOH and LiOH as a mineralizer aqueous solution, and adding the doping material M, M' or Cd to a starting material.
